# EUROPEAN PATENT APPLICATION

(11) **EP 2 645 558 A1**
(43) Date of publication of application: **02.10.2013**
(21) Application number: 12161448.1
(22) Date of filing: 27.03.2012
(51) Int. Cl.: H02M 7/00

(54) **Add-on boost converter for a solar energy system**

(71) Applicant: ABB Oy, 00380 Helsinki (FI)
(72) Inventor: Kangas, Jani, 00380 Helsinki (FI)
(74) Representative: Parta, Ari Petri

(57) **Abstract**

An aspect of the invention relates to a boost converter module for a solar energy system. The boost converter module comprises input poles (21, 22), output poles (31, 32) and a boost converter unit connected between the input poles (21, 22) and the output poles (31, 32), the input poles (21, 22) being adapted to be connected to a photovoltaic device feeding an input direct voltage (DC_{IN}), the boost converter unit being adapted to convert the input direct voltage (DC_{IN}) into an output voltage (V_{OUT}) that is higher than the input direct voltage (DC_{IN}) and to feed the output voltage (V_{OUT}) into the output poles (31, 32). The module is characterized in that the boost converter module comprises a maximum power point tracking (MPPT) unit, and in that the boost converter module further comprises a base (11) and a lid (12), and input connection means (23, 24) and output connection means (33, 34) on an inner surface of the base (11) and the lid (12) for connecting at least one wire to the input poles (21, 22) and the output poles (31, 32).

## Description

### FIELD OF THE INVENTION

The invention relates to solar energy systems, and more particularly to add-on devices for a existing solar energy system.

### BACKGROUND OF THE INVENTION

Large scale solar energy systems consist of arrays of photovoltaic devices, such as photovoltaic cells, connected to an inverter. Shading of a single photovoltaic cell or even a part of it causes a significant reduction of output power of the whole array and the solar energy system. Dividing the arrays into smaller arrays and adding inverters alleviates the shading problem because the shaded photovoltaic cell will reduce the output power of a smaller array.

One of the problems associated with the above arrangement is that it is very labour-intensive and expensive to increase efficiency of the system by adding more inverters and renew wiring systems of the photovoltaic cells whenever a photovoltaic cell is shaded. Shading may be caused by e.g. new buildings or growing trees.

### BRIEF DESCRIPTION OF THE INVENTION

An object of the present invention is thus to provide a method and an apparatus for implementing the method so as to alleviate the above disadvantages. The objects of the invention are achieved by a method and a device which are characterized by what is stated in the independent claims. The preferred embodiments of the invention are disclosed in the dependent claims.

A first aspect of the invention is a boost converter module for solar energy system. The boost converter module comprises input poles, output poles and a boost converter unit connected between the input poles and the output poles. The input poles are adapted to be connected to a photovoltaic device feeding an input direct voltage. The boost converter unit is adapted to convert the input direct voltage into an output voltage that is higher than the input direct voltage and to feed the output voltage into the output poles. The boost converter module is **characterized in that** it comprises a maximum power point tracking unit and in that it further comprises a base and a lid, and input connection means and output connection means on inner surfaces of the base and the lid for connecting at least one wire to the input poles and the output poles. The inner surfaces of the base and the lid are the surfaces which are against or next to each other when the lid is closed.

In an embodiment, the boost converter module comprises a hinge connecting the base and the lid, and the input connecting means and/or the output connecting means is adapted to connect a wire introduced in said means to the boost converter unit when the hinged lid is pressed against the base.

In an embodiment, the input connection means and/or the output connection means comprises crimping means for making a crimped connection with a wire introduced in said means when the hinged lid is pressed against the base.

In an embodiment, the input connection means and/or the output connection means comprises connection needles for penetrating insulation and making a connection with a wire introduced in said means when the hinged lid is pressed against the base.

In an embodiment, the boost converter module comprises a cable cutter for cutting a wire introduced in said boost converter module when the hinged lid is pressed against the base.

In an embodiment, the boost converter module is arranged to be powered solely by a photovoltaic device.

In an embodiment, the input connection means and/or the output connection means is a connector.

In an embodiment, the boost converter module further comprises an inverter unit.

In an embodiment, the boost converter module further comprises means for setting a bypass voltage and means for bypassing the boost converter unit when voltage at the input is higher than the set bypass voltage.

In an embodiment, the boost converter module further comprises means for setting a maximum output voltage.

In an embodiment, the boost converter module comprises multiple pairs of input poles and means for joining the input poles in order to combine the input power from multiple input poles in to a single input feed.

A second aspect of the invention is a solar energy system comprising a photovoltaic device and an inverter. The system is **characterized in that** it further comprises a boost converter module according to the first aspect of the invention.

A third aspect of the invention is a method for installing a boost converter module to an installed photovoltaic device system. The method is **characterized in that** the boost converter module comprises a base and a lid, and input connection means and output connection means between the base and the lid, wherein the method comprises the steps of:
- cutting a direct current wire into a first wire and a second wire,
- introducing the first wire in to the input connection means of the boost converter module,
- introducing the second wire in to the output connection means of the boost converter module, and
- pressing the lid of the boost converter module against the base of the boost converter module in order to connect said first wire to the boost converter input poles and said second wire to the boost converter output poles.

In an embodiment, the cutting of the direct current wire is performed with the boost converter module by pressing the lid of the boost converter module against the base of the boost converter module.

A fourth aspect of the invention is use of a boost converter module of the first aspect of the invention in a solar energy system.

An advantageous feature of the arrangement of the invention is that the presented boost converter module can be easily installed to an existing solar power system without changing any other devices.

### BRIEF DESCRIPTION OF THE DRAWINGS

In the following the invention will be described in greater detail by means of preferred embodiments with reference to the accompanying drawings, in which
Figure 1 illustrates an example of a boost converter module lid open; and
Figure 2 illustrates an example of a boost converter module installed to a wire.

### DETAILED DESCRIPTION OF THE INVENTION

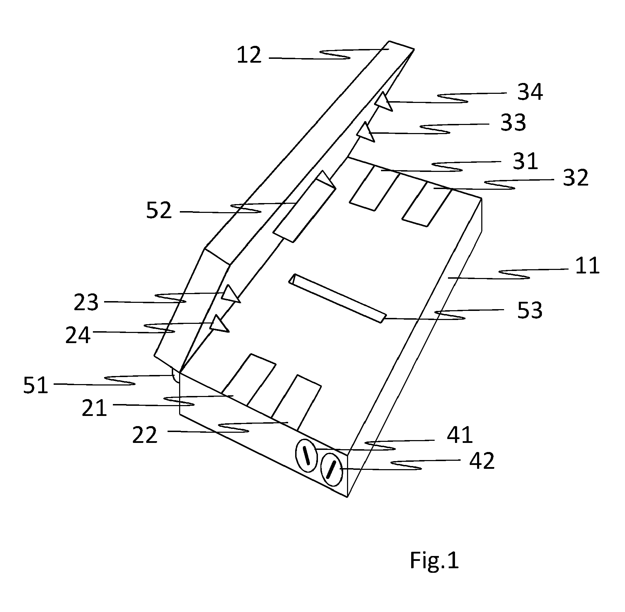

Figure 1 illustrates an embodiment of a boost converter module. The boost converter module comprises a base 11 and a lid 12 and a hinge 51 connecting the base 11 and the lid 12. The hinge 51 enables opening and closing of the lid 12. In another embodiment, there could be multiple hinges or the hinge may be omitted or substituted with some other known means for aligning the lid 12 with the base 11 and locking it therein.

The base 11 comprises an input having two input poles 21, 22 for direct voltage (DC) from a photovoltaic device. The base 11 also comprises an output having two output poles 31, 32 for direct voltage or alternating voltage, preferably on an opposite edge to the input poles. In an embodiment, the boost converter module may comprise multiple pairs of input poles 21, 22 and multiple pairs of output poles 31, 32. Multiple photovoltaic devices or multiple arrays of photovoltaic devices may be connected to a dedicated input in order to achieve optimal output in different conditions. The boost converter module has means for joining the multiple inputs from multiple photovoltaic devices in series or in parallel depending on the input direct voltage DC_{IN} in each of the inputs. The boost converter module is able to provide at least one sufficient output for an inverter device even in poor conditions by joining inputs from multiple photovoltaic devices. In normal conditions, the amount of active outputs may be the same as the amount of active inputs because each of the photovoltaic devices is producing a sufficient amount of power for an inverter device.

In an embodiment, the boost converter module may be powered solely by photovoltaic devices connected to the input poles. In normal daylight conditions the photovoltaic device provides enough power to the boost converter module to ensure normal operation and a desired output voltage. At sunset, when the power from the photovoltaic device's output power decreases, the boost converter module deactivates itself and may disconnect itself from the system. When the sun rises again, the boost converter module activates itself again and may connect to the system if it was disconnected. The boost converter module needs much less power to activate than inverter devices, so the boost converter module is already properly functioning by the time the inverter device is activated. The power of the photovoltaic devices at sunrise, when it is not sufficient for the inverter device, could be utilized to warm up and/or ventilate the boost converter module to evaporate any water which might have condensed to the boost converter module during nighttime. The boost converter module has to function only when power from photovoltaic device is available, so it does not require other power sources.

The input poles 21, 22 and/or the output poles 31, 32 may have different physical implementations depending on requirements and the system where the boost converter module will be installed. For example the input poles or the output poles may be screw-terminals, DC connectors, proprietary connectors, crimp terminals or pairs of conductors on a circuit board. Preferably the physical implementation of the input poles and/or the output poles is such that a wire inserted into input poles or output poles can be connected to the boost converter module by closing the lid 12. In another embodiment the input poles and the output poles may be in the lid 12.

The boost converter module comprises a boost converter unit connected between the input poles 21, 22 and the output poles 31, 32. The boost converter unit is preferably on a circuit board which is in the base 11 or the lid 12. In a normal operating mode, the boost controller unit raises the voltage from the input to the output so that the output voltage is higher than the input voltage. In a simple embodiment, the boost converter module's input poles 21, 22 are connected to the boost controller unit's input and the boost controller unit's output is connected to the boost controller module's output poles 31, 32.

The boost converter module may comprise means for setting different voltage thresholds for the boost converter unit. Preferably the boost converter module comprises at least means 41 for setting a bypass voltage and means for bypassing the boost converter unit when voltage at the input is higher than the set bypass voltage. Preferably the boost converter module also comprises means 42 for setting a maximum output voltage. A simple implementation for the means for setting voltage thresholds is to use a dedicated trimmer 41, 42 for each voltage. Also a slide switch, a set of buttons or similar arrangements may be used instead of trimmers. In an embodiment the trimmers may be substituted with a communication port for connecting to a computing device so that the settings can be made with e.g. a computer or mobile phone connected to the boost converter. The communication port may be realized with, for example, a serial, parallel, Ethernet or universal serial bus (USB) port, or the communications port is implemented to the input poles 21, 22 or the output poles 31, 32 of the boost converter module.

In an embodiment, the boost converter module comprises a maximum power point tracking (MPPT) unit in connection with the boost converter unit. The MPPT unit and the boost converter unit together are capable of drawing maximum power from photovoltaic cells using a wide input voltage range for producing a proper output for e.g. an inverter. Typically the boost controller output will be connected to an inverter device but in an embodiment the boost converter module may also comprise an inverter for producing AC power in a small scale.

The base 11 may comprise one or more slots 53 or cavities and the lid 12 can comprise one or more cutters 52, e.g. a blade. The blade 52 of the lid 12 protrudes to the slot 53 of the base 11, and the blade and slot combination is adapted to cut an electric wire between the blade and the slot when the lid 12 is closed. In an embodiment, the lid 12 comprises two blades 52 and the base 11 two slots 53 for the blades. When the lid is open, the boost converter module may be introduced around a wire. When the lid is closed, the wire inside the boost converter module is cut close to both input poles and output poles, and the closing of the lid also connects the cut ends of the wire to the input poles and the output poles.

The boost converter module comprises input connection means and output connection means between outer surfaces of the base 11 and the lid 12, preferably on the inner surfaces of the base 11 and the lid 12, for connecting wires to the input poles 21, 22 and the output poles 31, 32. The input connection means may comprise the input poles 21, 22 and the output connection means may comprise the output poles 31, 32. Preferably the input connection means and the output connection means are located on the inner surface of the base 11 and the lid 12. In an embodiment of Figure 1, the lid comprises needles 23, 24 as input connection means and needles 33, 34 as output connection means. When the lid 12 is closed, the needles penetrate an insulation of wire inserted to the input poles and/or the output poles and connect the wire electrically to the boost converter module. In an embodiment, input connection means and/or output connection means comprise means for making a crimp connection with a stripped wire end when the base 11 and the lid 12 are pressed together. In this case, for example the input poles 21, 22 and the input connection means 23, 24 are arranged to function as a crimper so that a stripped wire end introduced in to the input poles 21, 22 is deformed when the lid 12 is pressed against the base 11. The deforming of the wire fastens it to the input poles 21, 22 and creates an electrical contact from the wire to the boost converter module. The output may have a similar construction for crimping an output wire to the output poles 31, 32.

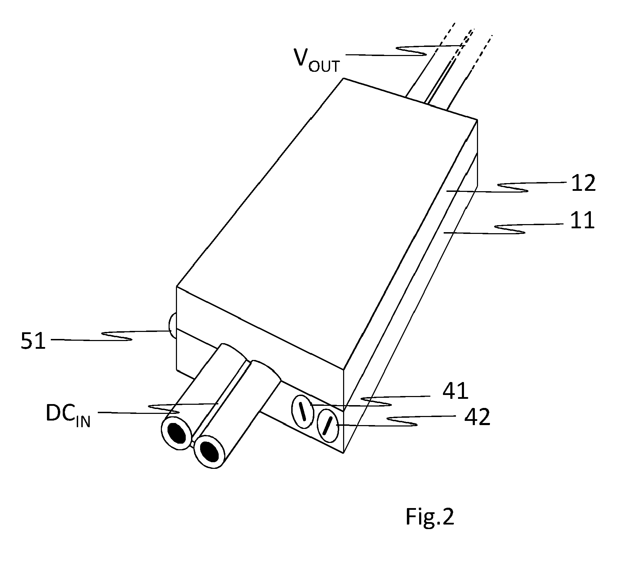

Figure 2 illustrates an installed boost converter module having input direct voltage DC_{IN} wire and output voltage V_{OUT} wire connected to the input poles and the output poles, respectively. The boost converter module is typically installed to a wire between a photovoltaic cell and e.g. an inverter of a solar energy system. In large-scale systems the photovoltaic cells are typically in arrays and the boost converter module may be installed to a wire between two photovoltaic cells. When installing the boost converter module, the wire in which the module is to be installed is cut into two wires, a first wire and a second wire. In an embodiment, the cutting of the wire may be performed with a cutter of the boost converter module.

Next, an open end of the first wire connected to the photovoltaic cell is placed into input connection means of the boost converter module. An open end of the second wire connected to, for example, an inverter, a load or another photovoltaic cell is placed into the output connection means of the boost converter module. When the open ends of the wires are in place, the lid of the boost converter module is closed by pressing it against the base of the boost converter module. The closing of the lid electrically connects the first wire to the input poles and the second wire to the output poles and also physically connects the wires to the boost converter module.

It will be obvious to a person skilled in the art that, as the technology advances, the inventive concept can be implemented in various ways. The invention and its embodiments are not limited to the examples described above but may vary within the scope of the claims.

## Claims

1. A boost converter module for a solar energy system, the boost converter module comprising input poles (21, 22), output poles (31, 32) and a boost converter unit connected between the input poles (21, 22) and the output poles (31, 32), the input poles (21, 22) being adapted to be connected to a photovoltaic device feeding an input direct voltage (DC_{IN}), the boost converter unit being adapted to convert the input direct voltage (DC_{IN}) into an output voltage (V_{OUT}) that is higher than the input direct voltage (DC_{IN}) and to feed the output voltage (V_{OUT}) into the output poles (31, 32), **characterized in that** the boost converter module comprises a maximum power point tracking (MPPT) unit, and **in that** the boost converter module further comprises a base (11) and a lid (12), and input connection means (23, 24) and output connection means (33, 34) on an inner surface of the base (11) and the lid (12) for connecting at least one wire to the input poles (21, 22) and the output poles (31, 32).

2. A boost converter module according to claim 1, **characterized in that** the boost converter module comprises a hinge (51) connecting the base (11) and the lid (12), and the module further comprises at least one of the following: the input connecting means (23, 24) and the output connecting means (33, 34), and is adapted to connect a wire introduced in said means to the boost converter unit when the hinged lid (12) is pressed against the base (11).

3. A boost converter module according to claim 1, **characterized in that** at least one of the following: the input connection means (23, 24) and the output connection means (33, 34), comprises crimping means for making a crimped connection with a wire introduced in said means when the hinged lid (12) is pressed against the base (11).

4. A boost converter module according to claim 1, **characterized in that** at least one of the following: the input connection means (23, 24) and the output connection means (33, 34), comprises connection needles for penetrating an insulation and making a connection with a wire introduced in said means when the hinged lid (12) is pressed against the base (11).

5. A boost converter module according to claim 1 or 4, **characterized in that** the boost converter module comprises a cable cutter (52) for cutting a wire introduced in said boost converter module when the hinged lid (12) is pressed against the base (11).

6. A boost converter module according to any one of claims 1 to 5, **characterized in that** at least one of the following: the input connection means and the output connection means, is a connector.

7. A boost converter module according to any one of claims 1 to 6, **characterized in that** the boost converter module is arranged to be powered solely by a photovoltaic device.

8. A boost converter module according to any one of claims 1 to 7, **characterized in that** the boost converter module further comprises an inverter unit.

9. A boost converter module according to any one of claims 1 to 8, **characterized in that** the boost converter module further comprises means for setting a bypass voltage and means for bypassing the boost converter unit when voltage at the input is higher than the set bypass voltage.

10. A boost converter module according to any one of claims 1 to 9, **characterized in that** the boost converter module further comprises means for setting a maximum output voltage.

11. A boost converter module according to any one of claims 1 to 10, **characterized in that** the boost converter module comprises multiple pairs of input poles (21, 22) and means for joining the input poles in order to combine the input power from the multiple input poles (21, 22) into a single input feed.

12. A solar energy system comprising a photovoltaic cell and an inverter, **characterized in that** the system further comprises a boost converter module according to any one of claims 1 to 11.

13. A method for installing a boost converter module to an existing photovoltaic cell system, **characterized in that** the boost converter module comprises a base (11) and a lid (12), and input connection means (23, 24) and output connection means (33, 34) on an inner surface of the base (11) and the lid (12), wherein the method comprises:
- cutting a direct current wire into a first wire and a second wire,
- introducing the first wire in to the input connection means (23, 24) of the boost converter module,
- introducing the second wire in to the output connection means (33, 34) of the boost converter module, and
- pressing the lid (12) of the boost converter module against the base of the boost converter module in order to connect said first wire to the boost converter input poles (21, 22) and said second wire to boost converter output poles (31, 32).

14. A method according to claim 13, **characterized in that** the cutting of the direct current wire is performed with said boost converter module by pressing the lid (12) of the boost converter module against the base (11) of the boost converter module.

15. Use of a boost converter module according to any one of claims 1 to 11 in a solar energy system.
